# EUROPEAN PATENT APPLICATION

(11) **EP 4 764 440 A1**
(43) Date of publication of application: **24.06.2026**
(21) Application number: 24221467.4
(22) Date of filing: 19.12.2024
(51) Int. Cl.: G01M 3/04, G01M 3/18, G01M 3/36, G01L 1/20, G01L 5/101, H01M 10/48

(54) **DETECTION CABLE AND METHOD FOR DETECTING A LEAKAGE AND A SWELLING OF AT LEAST ONE BATTERY**

(71) Applicant: ABB SCHWEIZ AG, 5400 Baden (CH)
(72) Inventor: HE, Minglong, 4310 Rheinfelden (CH); MARIUCCI, Giacomo, 6900 Lugano (CH)
(74) Representative: Maiwald GmbH

(57) **Abstract**

The present disclosure relates to a detection cable (10) configured to detect a leakage and a swelling of at least one battery (42). The detection cable (10) comprises a first leakage detection wire (18), a second leakage detection wire (22) and a swelling detection wire (26), all wires (18, 22, 26) are arranged inside a liquid-permeable cable jacket (14). Each leakage detection wire (18, 22) comprises a conductor wire (34, 35) provided inside a liquid-permeable wire jacket (30, 32), so that a leakage liquid (60) entering the liquid-permeable cable jacket (14) changes a resistance (R_{L}) between the conductor wires (34, 35) of both leakage detection wires (18, 22). The swelling detection wire (26) comprises an elastic material (36) with conductive additives (38), so that a resistance (Rs) of the swelling detection wire (26) changes when it is elongated.

## Description

### FIELD OF THE INVENTION

The present invention relates a detection cable and method for detecting a leakage and a swelling of at least one battery. The invention further relates to a detection system for detecting a leakage and swelling and an uninterruptable power supply system.

### BACKGROUND

Uninterruptible Power Supplies (UPS) play a crucial role in ensuring the reliability of power for sensitive electronic equipment. However, like all technologies, UPS systems can experience issues, particularly with their batteries. Among the most concerning problems are leaks and swelling, which can pose safety hazards and impact system performance. Leaks typically occur due to electrolyte degradation or physical damage, leading to potential corrosion and contamination of surrounding components. Swelling, on the other hand, is often indicative of gas buildup within the battery, usually caused by overcharging, aging, or temperature extremes. Understanding these issues is essential for maintaining the longevity and safety of UPS systems, as well as for preventing costly downtime in critical operations. A defect of the UPS system often is detected by a hydrogen sensor, a smoke sensor or a temperature sensor.

CN101813549B pertains to a method and system for detecting liquid leakage in the battery pack of an uninterruptible power supply (UPS) system. It utilizes the vector characteristics of the current flowing through the positive and negative terminals of the battery pack to determine if leakage has occurred. The system includes a sampling module to measure the current values and a judgment module to assess whether these values are equal; if they are not, leakage is indicated. This detection can be performed while the UPS system is operational, eliminating the need to stop the system or open the battery cabinet. The present disclosure aims to enhance safety by preventing potential hazards such as fire or explosion due to battery leakage, thereby ensuring reliable UPS performance.

### SUMMARY

There may be a need to provide means for early detecting a swelling or a leakage of at least one battery. Further, there may be a need for a method to disconnect the battery in case of a swelling or a leakage.

This need may be met by a detection cable for detecting a leakage and a swelling of at least one battery having the features of claim 1 or claim 2. According to the present disclosure a method for detecting a leakage and a swelling of at least one battery having the features of claim 10 and a detection system having the features of claim 11 is disclosed. Embodiments of the present disclosure are specified in the dependent claims and the following description.

According to an aspect of the present disclosure a detection cable configured to detect a leakage and a swelling of at least one battery is proposed. The detection cable comprises a first leakage detection wire, a second leakage detection wire and a swelling detection wire, all wires are arranged inside a liquid-permeable cable jacket. Each leakage detection wire comprises a conductor wire provided inside a liquid-permeable wire jacket, so that a leakage liquid entering the liquid-permeable cable jacket changes a resistance between the conductor wires of both leakage detection wires. The swelling detection wire comprises an elastic material with conductive additives, so that a resistance of the swelling detection wire changes when it is elongated.

The liquid-permeable jacket and the liquid-permeable wire jacket allow a leakage liquid of a battery entering inside the detection cable and the leakage detection wires. The leakage-liquid, which is electrically conductive, thereby electrically connects both conductor wires provided inside the wire jackets, so that the resistance between both cables in case of a leakage is lowered. A leakage of a battery therefore can be easily detected. During a swelling of the battery an outer surface of the battery bulge. This leads to an elongation of the swelling detection wire. The elastic material of the swelling detection wire permits such an elongation. Because of the conductive additives embedded in the elastic material, a resistance of the swelling detection wire can be measured. When the swelling detection wire is elongated the diameter is decreased, so that the conductive additives come closer to each other. Thereby the resistance of the swelling detection wire decreases. This resistance change can be measured so that it can be assumed that a swelling of the at least one battery occurred.

With the detection cable it is therefore possible detection a leakage and a swelling at an early stage before a fire or an explosion of the battery occur. With such a detection cable the safety can be increased. Additionally, such a detection cable can be economically provided for monitoring of at least one battery.

According to a further aspect of the present disclosure an alternative detection cable configured to detect a leakage and a swelling of at least one battery is proposed. The detection cable comprises a leakage detection wire, and a swelling detection wire, all wires are arranged inside a liquid-permeable cable jacket. The swelling detection wire comprises an elastic material with conductive additives, so that a resistance of the swelling detection wire changes when it is elongated. The leakage detection wire comprises a conductor wire provided inside a liquid-permeable wire jacket, so that a leakage liquid entering the liquid-permeable cable jacket changes a resistance between the conductor wire and the swelling detection wire.

The liquid-permeable jacket and the liquid-permeable wire jacket allow a leakage liquid of a battery entering inside the detection cable and the leakage detection wire. The leakage-liquid, which is electrically conductive, thereby electrically connects the conductor wire provided inside the wire jacket and the swelling detection wire, so that the resistance between the leakage detection wire and the swelling detection wire in case of a leakage is lowered. A leakage of a battery therefore can be easily detected. In case of a swelling the swelling detection wire is elongated. Due to this elongation the resistance of the swelling detection wire is lowered. This resistance change can be measured. A swelling of a battery thereby does not lower the resistance between the leakage detection wire and the swelling detection wire so the battery fault can be precisely determined. With this disclosure it is possible to measure a leakage and a swelling by using two detection wires, only. A thickness and the manufacturing cost of such a detection cable can be lowered.

In a further embodiment of the present disclosure, the elastic material comprises a silicon material. A silicon material has the advantage that it is elastically and that it has a low price so that with this material an economical swelling detection is possible. Apart from this, a silicon material has good thermal stability and a high melting point, so that also a hot battery does not deteriorate the swelling detection capacity of the swelling wire.

In a further embodiment, the conductive additive comprises carbon black. Compared to other conductive materials like metals or carbon nanotubes, carbon black has low costs. Carbon black further comprises a high electric conductivity, so that swelling can be measured with a high accuracy, and a low weight. With such a conductive additive an economic swelling detection with a high accuracy is possible.

Advantageously, the liquid-permeable wire jacket comprises a porous material. Using a porous material for the wire jacket has the advantage that such a wire jacket is lighter than a solid material. A porous material further is resistant to corrosion from chemicals like leakage liquid. Apart from the fact that porous material provides a good liquid-permeability, such a material also having lower manufacturing costs than e.g. solid materials, so that such a detection cable can be made available more economically.

Preferably, the detection cable comprises an adhesive layer so that it can be bonded to at least one battery. With such an adhesive layer the detection cable can be easily attached to the battery. A separate step and means for attaching the detection cable to a battery or providing an adhesive between the battery and the detection cable can be omitted.

In a further advantageous development, the detection cable comprises a rectangular cross section. A rectangular cross section of the detection cable has the advantage that the cable provides a plane surface for bonding the cable to the battery. Such a cross section therefore simplifies the bonding of the cable to the battery and improves a durability of the bonding joint.

In an alternative embodiment the detection cable comprises a circular cross section. Detection cables with a circular cross section are easier to manufacture so that these cables are also more economically than other cable cross sections.

In a preferred embodiment, the detection cable additionally comprises a temperature-detection-wire. With such a temperature-detection-wire the temperature of the battery can be measured during the operation of the battery. As a temperature increase in a certain extent also can be an indicator for a battery defect, with a temperature-detection-wire such defects can be detected at an early stage. A thermal runaway of the battery thereby can be detected. By using such a detection cable the safety can be improved.

The present disclosure further proposes a method for detecting a leakage and a swelling of at least one battery with such a detection cable. The method comprises the steps of measuring the resistance between the leakage detection wires or the resistance between the leakage detection wire and the swelling detection wire, and the resistance of the swelling detection wire, generating a leakage-fault-signal, in case the resistance of the leakage detection wires or the resistance between the leakage detection wire and the swelling detection wire, changes, and open a switch or conductor for disconnecting the at least one battery. A swelling-fault-signal is generated, in case the resistance of the swelling detection wire changes, and a switch or conductor is opened for disconnecting the at least one battery in case that the resistance of the swelling detection wire exceeds a threshold.

By generating a leakage-fault-signal or a swelling-fault-signal the user can be directly informed about the cause of fault. The maintenance or repair of the at least one battery therefore is simplified. A swelling-fault-signal also leads to a disconnection of the leaking battery. Such a disconnection preferably is conducted in an automatic manner. By disconnecting the battery, a fire or explosion can be prevented.

Although, a battery may undergo a swelling to a certain extend a swelling as such is less critical than a leakage of the battery. Therefore, if a swelling is detected the battery can still be operated until the swelling exceeds a specific dimension. This dimension is defined by the threshold for the resistance of the swelling wire. With the method the battery can be disconnected before the battery explodes due to an overpressure of flammable gases such as H2 inside the battery. This method therefore provides a safe operation of the battery.

The present disclosure further proposes a detection system for detecting a leakage and a swelling of at least one battery. The detection system comprises at least one detection cable, arranged along an outer side surface of at least one battery, a measuring unit for detecting a resistance of the leakage detection wires or the resistance of the leakage detection wire and the swelling detection wire, and the swelling detection wire, and a control unit for detecting a fault of the at least one battery.

With such a detection system, only a few components are required to monitor at least one battery for leakage and swelling. The detection system therefore provides an economical solution for monitoring at least one battery, so that the safety is improved.

A preferred embodiment specifies that the detection cable is arranged with a vertical distance of lower than 10cm from a battery sealing or a battery vent. The vertical distance is thereby measured in relation to gravity below the battery sealing or the vent opening. Accordingly, also the detection cable is arranged below the battery sealing or the battery vent. Thereby it can be ensured that a leakage exiting the e.g. sealing and running in direction of gravity, comes in contact with the detection cable, so that the leakage can be detected. Because of the vertical distance below 10cm, a leakage can be detected at an early stage.

The arrangement of the detection cable at the specified position also has the advantage that a bulge of the battery in this region due to the rising gas inside the battery is most probably so that a swelling at this position also can be detected at an early stage.

Further, an uninterruptable power supply system comprising at least one battery with a detection system is proposed. Such an uninterruptable power supply system comprising the detection system has the advantage that a swelling and a leakage can be detected before the at least one battery fail. The at least one battery therefore can be changed before the battery fails. The reliability of an uninterruptable power supply system thereby can be improved. As an explosion or fire of the batteries can be prevented with the detection system, the safety of the uninterruptable power supply system also can be increased.

Preferably, the system comprises a plurality of batteries with one detection cable arranged along an outer side of all batteries. Instead of a separate detection cable for each battery, one detection cable is arranged to all batteries. Although, all batteries are connected with a single detection cable a leakage and swelling of one battery can still be determined. The uninterruptable power supply system thereby can be simplified, and a leakage and swelling detection can be economically provided.

According to a preferred embodiment the at least one battery is an aqueous battery. An aqueous battery uses water-based electrolytes instead of organic solvents. Aqueous electrolytes are typically non-toxic and non-flammable, making aqueous batteries safer to handle and use, compared to traditional lithium-ion batteries that use flammable organic solvents. These batteries are also less prone to thermal runaway. As an aqueous battery preferably a Ni-Zn battery is used. These batteries have a high power density and low material costs per cell.

The above aspects and examples will become apparent from and be elucidated with reference to the embodiments described hereinafter.

### BRIEF DESCRIPTION OF THE DRAWINGS

The subject matter of the present disclosure will be explained in more details in the following description illustrated in the drawings, in which:
- Figure 1: Embodiment of a detection cable according to an exemplary embodiment of the present disclosure,
- Figure 2a: Cross-sectional view of the detection cable according to figure 1,
- Figure 2b: Cross-sectional view of a second embodiment of the detection cable according to the invention,
- Figure 2c: Cross-sectional view of a third embodiment of the detection cable according to an exemplary embodiment of the present disclosure,
- Figure 2d: Cross-sectional view of a fourth embodiment of the detection cable according to an exemplary embodiment of the present disclosure,
- Figure 3: Cross-sectional view of a battery with a detection cable according to figure 2b,
- Figure 4: Schematic representation of a detection system according to an exemplary embodiment of the present disclosure,
- Figure 5: Schematic representation of a detection system according to a second embodiment of the present disclosure,
- Figure 6: Uninterruptable power supply system, and
- Figure 7: Method for detecting a leakage and a swelling of at least one battery.

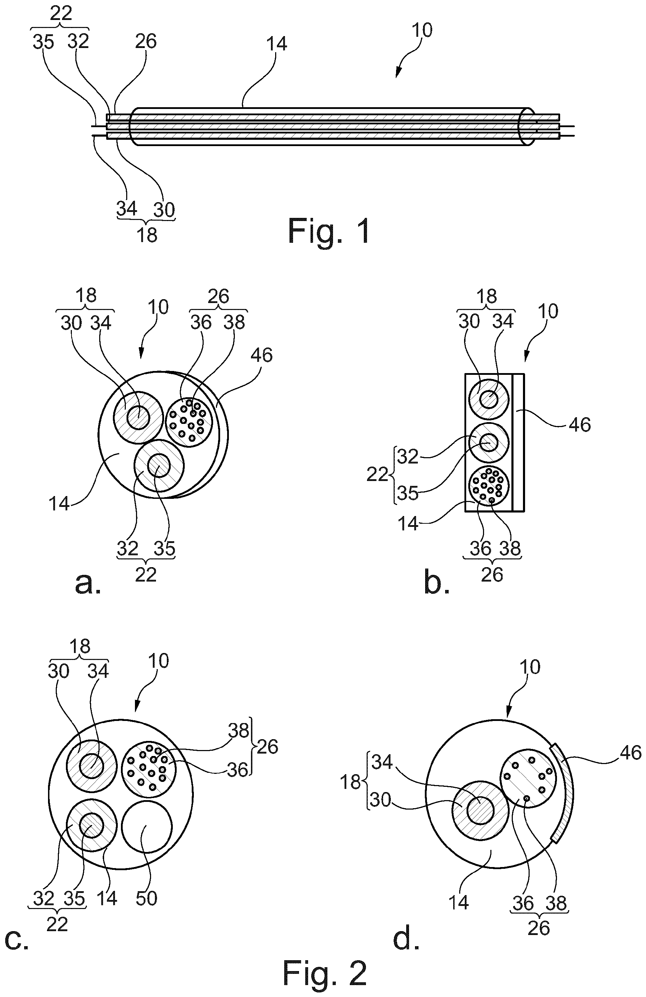

Figure 1 shows an embodiment of a detection cable 10 according to an exemplary embodiment of the present disclosure. The detection cable 10 comprises the cable jacket 14 which is permeable to liquid. At an inner side of the cable jacket 14, three detection wires 18, 22, 26 are arranged. The detection wires 18, 22, 26 thereby comprise a first leakage detection wire 18 and a second leakage detection wire 22. Both leakage detection wires 18, 22 thereby comprise a similar structure. Each leakage detection wire 18, 22 is provided with a wire jacket 30, 32, which also is liquid-permeable. The wire jacket 30, 32 can be made of a porous material. Inside each wire jacket 30, 32 a conductor wire 34, 35 is arranged, which is electrically conductive. The detection wires 18, 22, 26 further comprise a swelling detection wire 26, which also is arranged inside the cable jacket 14. The swelling detection wire 26 is made of an elastic material 36 like a silicon material.

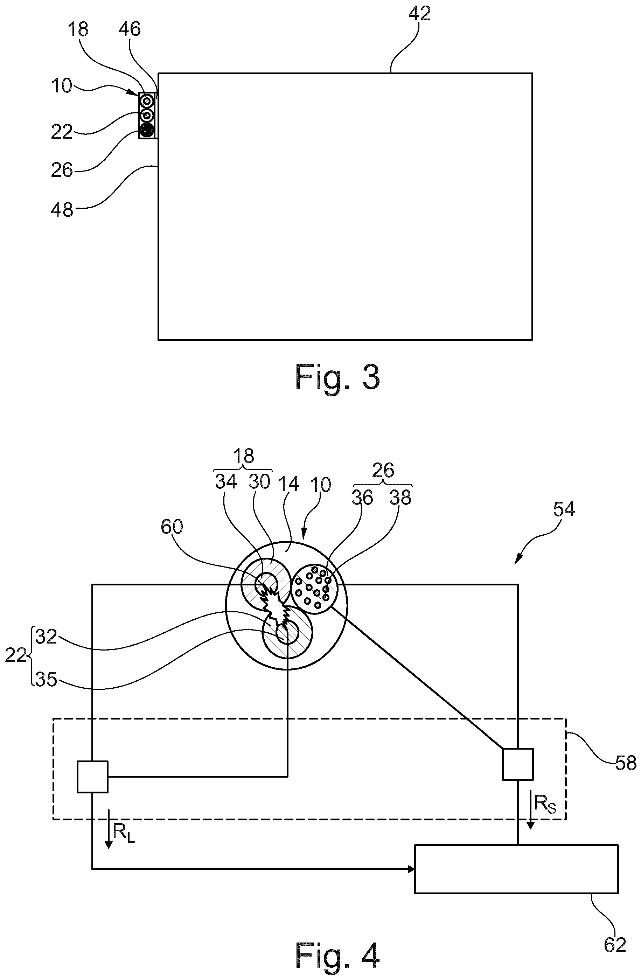

In figure 2a a cross-sectional view of the detection cable 10 according to figure 1 is shown. In this embodiment the detection cable 10 has a circular cross section. This figure shows the three detection wires 18, 22, 26, which are arranged inside the cable jacket 14. It is further shown that the swelling detection wire 26 comprises conductive additives 38, which are embedded in the elastic material 36. The conductive additive 38 in the present case comprises carbon black. For attaching the detection cable 10 to a battery 42 (see figure 3), an adhesive layer 46 is provided on an outer surface of the cable jacket 14. By means of this adhesive layer 46, the detection cable 10 can be bonded to an outer side surface 48 (see figure 3) of the battery 42.

A further embodiment of the detection cable 10 is shown in figure 2b. In this figure the detection cable 10 has a rectangular cross-section. In contrast to the circular cross section, this form of the detection cable 10 provides an easier bonding to the outer side surface 48 of the battery 42 due to the plane adhesive layer 46. Figure 2c shows a further embodiment of the detection cable 10. In this embodiment a temperature-detection-wire 50 is additionally arranged inside the cable jacket 14. By means of this temperature-detection-wire 50 it is possible to detect the temperature at the outer side surface 48 of the battery 42. An increased temperature of the battery 42 also could be an indicator for a battery defect. By means of this temperature-detection-wire 50 a defect can be detected at an early stage.

Figure 2d shows a cross-sectional view of a fourth embodiment of the detection cable according to an exemplary embodiment of the present disclosure. This embodiment differs to the before described embodiments in that instead of two leakage detection wires 18, 22, only one leakage detection wire 18 is used. The detection cable 10 therefore comprises two detection wires 18, 26, only. The structural design of the two detection wires 18, 26 thereby is like the structural design of the detection cables 18, 22, 26 described before.

Figure 3 shows a cross-sectional view of the battery 42 with the detection cable 10 according to figure 2b. The detection cable 10 is bonded to the outer side surface 48 of the battery 42. In the event of a leakage of the battery 42, a leakage-liquid exits at the outer side surface 48 of the battery 42. This leakage-liquid enters the detection cable 10 through the liquid-permeable cable jacket 14. As the wire jacket 30, 32 of the first and second leakage detection wire 18, 22 also is liquid permeable, the leakage-liquid comes into contact with both conductor wires 34, 35. Due to this contact, a resistance R_{L} between both conductor wires 34 changes, which can be detected.

In an event of a battery swelling due to an H2 release inside the battery 42, an outer side surface 48 of the battery 42 bulge. In this case the swelling detection wire 26 is elongated. This elongation of the swelling detection wire 26 also leads to a different resistance R_{S} of this wire 26 due to a smaller distance between the conductive additives 38. Accordingly, a swelling of the battery 42 also can be detected at an early stage.

A schematic representation of a detection system 54 according to an exemplary embodiment of the present disclosure is shown in figure 4. With such a detection system 54 swelling and leakage of the battery 42 can be detected. The detection system 54 comprises the detection cable 10, which is arranged to an outer side surface 48 of at least one battery 42 (not shown). The detection system 54 further comprises a measuring unit 58, for measuring the resistance R_{L} between the first and the second leakage detection wire 18, 22 and the resistance Rs of the swelling detection wire 26. For measuring the resistance R_{L} between the leakage detection wires 18, 22 the measuring unit 58 is connected to the conductor wires 34, 35 of both leakage detection wires 18, 22. In the case of leakage-liquid 60 between both conductor wires 34, 35 the resistance R_{L} between both conductor wires 34, 35 is reduced. The resistance R_{L} is provided to a control unit 62 of the detection system 54, which in this event detects a fault of at least one battery 42. The same is true for the swelling resistance R_{S} measurement of the swelling detection wire 26.

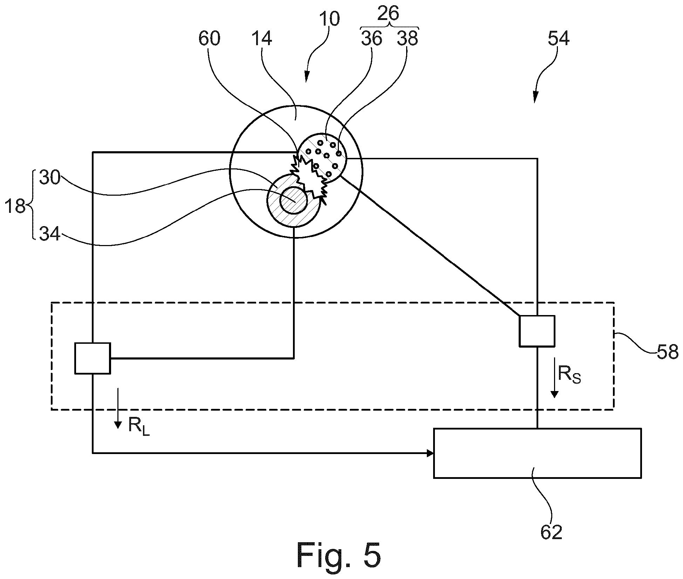

A further schematic representation of a detection system 54 according to an exemplary embodiment of the present disclosure is shown in figure 5. This embodiment differs to the embodiment of figure 4 in that the leakage resistance R_{L} is measured between the conductor wire 34 of the leakage detection wire 18 and the swelling detection wire 26. In case of a leakage-liquid 60 between the conductor wire 34 and the swelling detection wire 26, the resistance R_{L} between both detection wires 18, 26 is reduced. The resistance R_{L} is provided to a control unit 62 of the detection system 54, which in this event detects a fault of at least one battery 42. The swelling resistance R_{S} is measured as described in figure 4. In contrast to the detection system 54 according to figure 4, two detection wires 18, 26 are required, only.

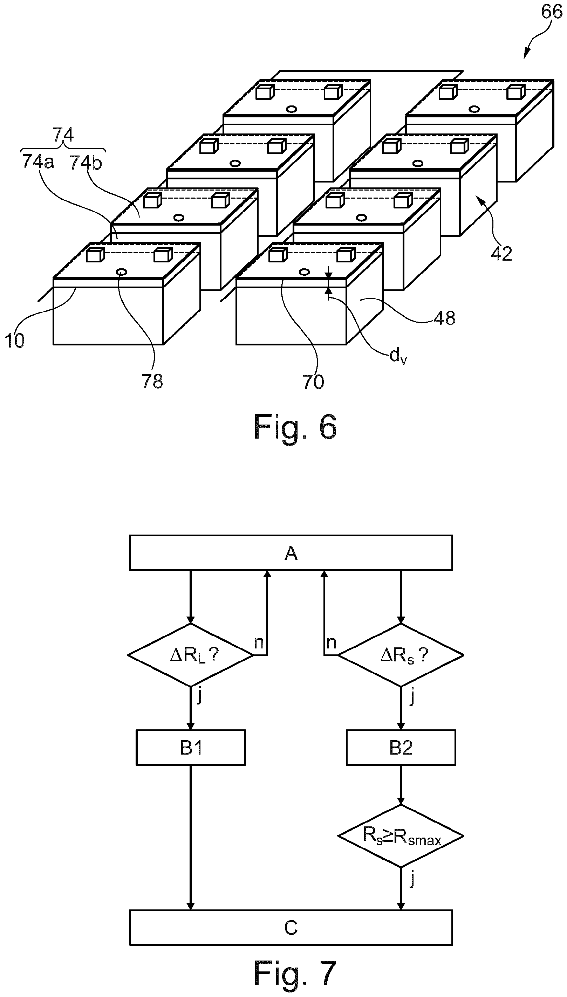

In figure 6 an uninterruptible power supply system 66 is shown. The uninterruptible power supply system 66 comprises a plurality of batteries 42 for establishing an uninterrupted power supply. At an outer side surface 48 of all batteries 42 the detection cable 10 is arranged. For all batteries 42 one detection cable 10 is used, only. In other words, the detection cable 10 is attached to all batteries 42 of the uninterruptible power supply system 66. In the event of a leakage or swelling of at least one battery 42 of the uninterruptible power supply system 66 this is detected by the detection system 54 connected with the detection cable 10. In the shown example the detection cable 10 is arranged at the outer side surface 48 of the batteries 42 with a vertical distance dv of lower than 10 cm from a battery sealing 70, connecting a bottom part 74a of a battery housing 74 with a top part 74b of the battery housing 74. All batteries 42 further provide a battery vent 78 for venting gas generated during a degradation of the battery 42.

A method for detecting a leakage and a swelling of at least one battery 42 is shown in figure 7. The method is demonstrated for a leakage detection cable 10 according to figures 2a-c. In a first step A of the method, the resistance R_{L} between the leakage detection wires 18, 22 and the resistance Rs of the swelling detection wire 26 is continuously measured. In case that a resistance change ΔR_{L} of the leakage detection wires 18, 22 occurs, a leakage fault signal B1 is generated. Due to this fault signal a switch or conductor (not shown) is opened C disconnecting the batteries 42. By disconnecting the batteries 42, a resulting fire or explosion due to an uncovered leakage of the batteries 42 can be avoided.

If a resistance change ΔR_{S} of the swelling detection wire 26 occurs, a swelling fault signal B2 is generated. However, in this event the resistance Rs of the swelling detection wire 26 is still monitored and the batteries are still operating. Only in the case that the measured resistance Rs of the swelling detection wire 26 exceeds a given threshold R_{Smax}, the switch or conductor is opened C for disconnecting the batteries 42. Accordingly, the swelling of the batteries 42 is tolerated in a certain extent.

### List of reference numbers

- 10: detection cable
- 14: cable jacket
- 18: first leakage detection wire
- 22: second leakage detection wire
- 26: swelling detection wire
- 30: wire jacket first leakage detection wire
- 32: wire jacket second leakage detection wire
- 34: conductor wire first leakage detection wire
- 35: conductor wire second leakage detection wire
- 36: elastic material
- 38: conductive additive
- 42: battery
- 46: adhesive layer
- 48: outer side surface battery
- 50: temperature-detection-wire
- 54: detection system
- 58: measuring unit
- 60: leakage liquid
- 62: control unit
- 66: uninterruptible power supply system
- 70: battery sealing
- 74: battery housing
- 74a: bottom part
- 74b: top part
- 78: battery vent
- d_{V}: vertical distance
- R_{L}: resistance leakage detection wires
- R_{S}: resistance swelling detection wire
- ΔR_{L}: resistance change
- ΔR_{S}: resistance change
- R_{Smax}: swelling threshold
- A: method step
- B1: method step
- B2: method step
- C: method step

## Claims

1. Detection cable (10), configured to detect a leakage and a swelling of at least one battery (42), comprising:
a first leakage detection wire (18), a second leakage detection wire (22) and a swelling detection wire (26), all wires (18, 22, 26) are arranged inside a liquid-permeable cable jacket (14),
wherein each leakage detection wire (18, 22) comprises a conductor wire (34, 35) provided inside a liquid-permeable wire jacket (30, 32), so that a leakage liquid (60) entering the liquid-permeable cable jacket (14) changes a resistance (R_{L}) between the conductor wires (34, 35) of both leakage detection wires (18, 22),
wherein the swelling detection wire (26) comprises an elastic material (36) with conductive additives (38), so that a resistance (Rs) of the swelling detection wire (26) changes when it is elongated.

2. Detection cable (10), configured to detect a leakage and a swelling of at least one battery (42), comprising:
a leakage detection wire (18), and a swelling detection wire (26), all wires (18, 26) are arranged inside a liquid-permeable cable jacket (14),
wherein the swelling detection wire (26) comprises an elastic material (36) with conductive additives (38), so that a resistance (Rs) of the swelling detection wire (26) changes when it is elongated,
wherein the leakage detection wire (18) comprises a conductor wire (34) provided inside a liquid-permeable wire jacket (30), so that a leakage liquid (60) entering the liquid-permeable cable jacket (14) changes a resistance (R_{L}) between the conductor wire (34) and the swelling detection wire (26).

3. Detection cable (10) according to claim 1 or 2, wherein the elastic material (36) comprises a silicon material.

4. Detection cable (10) according to one of the preceding claims , wherein the conductive additive (38) comprises carbon black.

5. Detection cable (10) according to one of the preceding claims, wherein the liquid-permeable wire jacket (30, 32) comprises a porous material.

6. Detection cable (10) according to one of the preceding claims, wherein the detection cable (10) comprises an adhesive layer (46) so that it can be bonded to at least one battery (42).

7. Detection cable (10) according to one of the preceding claims, wherein the detection cable (10) comprises a rectangular cross section.

8. Detection cable (10) according to one of the claims 1 to 6, wherein the detection cable (10) comprises a circular cross section.

9. Detection cable (10) according to one of the preceding claims, wherein the detection cable (10) additionally comprises a temperature-detection-wire (50).

10. Method for detecting a leakage and a swelling of at least one battery (42) with a detection cable (10) according to claims 1 to 9, comprising the steps:
- Measuring (A) the resistance (R_{L}) between the leakage detection wires (18, 22) or the resistance (R_{L}) between the leakage detection wire (18) and the swelling detection wire (26), and the resistance (Rs) of the swelling detection wire (26),
- Generating (B1) a leakage-fault-signal, in case the resistance (R_{L}) between the leakage detection wires (18, 22) or the resistance (R_{L}) between the leakage detection wire (18) and the swelling detection wire (26), changes, and open (C1) a switch or conductor for disconnecting the at least one battery (42),
- Generating (B2) a swelling-fault-signal, in case the resistance (Rs) of the swelling detection wire (26) changes, and
- Open (C2) a switch or conductor for disconnecting the at least one battery (42) in case that the resistance (R_{S}) of the swelling detection wire exceeds a threshold (R_{Smax}).

11. Detection system (54) for detecting a leakage and a swelling of at least one battery (42), comprising at least one detection cable (10) according to one of claims 1 to 9, arranged along an outer side surface (48) of at least one battery (42), a measuring unit (58) for detecting a resistance (R_{L}) of the leakage detection wires (18, 22) or the resistance (R_{L}) of the leakage detection wire (18) and the swelling detection wire (26), and a resistance (Rs) of the swelling detection wire (26), and a control unit (62) for detecting a fault of the at least one battery (42) and conducting a method according to claim 10.

12. Detection system (54) according to claim 11, wherein the detection cable (10) is arranged with a vertical distance (d_{V}) of lower than 10cm from a battery sealing (70) or a battery vent (78).

13. Uninterruptable power supply system (66) comprising at least one battery (42) with a detection system (54) according to claims 11 or 12.

14. Uninterruptable power supply system (66) according to claim 13, wherein the system (66) comprises a plurality of batteries (42) with one detection cable (10) arranged along an outer side surface (48) of all batteries (42).

15. Uninterruptable power supply system (66) according to claim 13 or 14, wherein the at least one battery (42) is an aqueous battery.
